Europäisches Patentamt

European Patent Office

Office européen des brevets

(19)

(11) Numéro de publication: **0 122 821**

**A1**

(12) **DEMANDE DE BREVET EUROPEEN**

(21) Numéro de dépôt: **84400422.6**

(22) Date de dépôt: **02.03.84**

(51) Int. Cl.³: **H 05 K 7/12**
**F 16 B 9/02**

(30) Priorité: **11.03.83 FR 8304050**

(43) Date de publication de la demande:
**24.10.84 Bulletin 84/43**

(84) Etats contractants désignés:
**DE FR GB IT NL**

(71) Demandeur: **SOCIETE D'ELECTRONIQUE INDUSTRIELLE DE MOULINS SELIMO 173, boulevard Haussmann F-75379 Paris Cédex 08(FR)**

(72) Inventeur: **Billon, Jean-Pierre THOMSON-CSF SCPI 173, bld Haussmann F-75379 Paris Cedex 08(FR)**

(74) Mandataire: **Grynwald, Albert et al, THOMSON-CSF SCPI 173, Bld Haussmann F-75379 Paris Cedex 08(FR)**

(54) **Dispositif de fixation d'un objet, notamment un transformateur, à un fond.**

(57) Ce dispositif comprend une plaque de base (4) fixable au fond et des crochets (5, 6) solidaires de cette plaque. L'objet est maintenu entre les redans (18) des crochets et ladite plaque ou un support (29) qui en est solidaire.

Ce dispositif de fixation (3) est tel qu'avant le montage les crochets sont éloignés l'un de l'autre afin que l'objet puisse être introduit sur la plaque (4) ou sur le support (29) qui en est solidaire sans avoir à écarter lesdits crochets, ces derniers étant installés en position active de fixation par l'application de la plaque de base (4) contre le fond (2), notamment par vissage.

FIG_1

EP 0 122 821 A1

1

# DISPOSITIF DE FIXATION D'UN OBJET, NOTAMMENT UN TRANSFORMATEUR, A UN FOND.

L'invention est relative à un dispositif de fixation d'un objet à un fond qui comprend une plaque de base applicable contre le fond et des crochets, l'objet étant maintenu entre cette plaque et les crochets, lesquels sont effacés lors de la mise en place de l'objet.

Certains appareils, notamment ceux du type électronique tels que les récepteurs radiophoniques, les téléviseurs, les amplificateurs etc... sont composés d'éléments mécaniquement indépendants les uns des autres mais rassemblés dans un boîtier commun. Ces appareils doivent, pour qu'ils soient d'un usage et d'un transport aisés, être d'une cohésion suffisante. Il faut, en particulier, que les pièces lourdes. tels que les transformateurs, de ces appareils soient bien fixées afin de ne pas détériorer les autres composants. De plus, comme il s'agit d'appareils fabriqués en grande série, la fixation doit être économique et d'un montage facile.

Jusqu'à présent pour fixer un transformateur au fond d'un appareil, on fait appel à un support en matière plastique comprenant une plaque de base et des crochets de fixation. La plaque de base est fixée, notamment par vissage, au fond et les crochets sont du type à encliquetage, c'est-à-dire qu'ils s'effacent lorsqu'on introduit le transformateur entre ceux-ci et reviennent, par leur propre élasticité, dans la position de départ quand ce transformateur est installé, ce dernier étant ainsi maintenu entre la plaque de base et les redans des crochets.

Pour qu'un tel dispositif de fixation soit efficace il est nécessaire que la force de rappel élastique de la tige des crochets soit importante, ce qui rend le montage malaisé. Si la force de rappel est diminuée, la sécurité de la fixation en pâtit et le transformateur peut se libérer de sa fixation lors d'essais normalisés de chutes.

L'invention ne présente pas ces inconvénients.

Elle est caractérisée en ce que le dispositif est tel qu'avant montage les crochets sont normalement effacés et qu'ainsi il n'y a pas d'effort à exercer pour introduire l'objet à fixer entre ces crochets et c'est la fixation de la plaque de base du dispositif contre le fond qui dispose et maintient les crochets en position active de fixation.

Dans les dispositifs antérieurement connus, du type à encliquetage, l'effort à exercer pour le montage est d'autant plus important qu'est grande la longueur des redans des crochets. Cette longueur des redans doit donc ne pas être trop grande pour que le montage ne soit pas trop malaisé. Le dispositif de fixation selon l'invention n'étant pas du type à encliquetage, les redans des crochets peuvent avoir une plus grande longueur sans qu'il en résulte de conséquences négatives pour le montage ; en outre, cette plus grande longueur augmente d'autant la sécurité de la fixation.

Dans une réalisation, la plaque de base est plane et de deux côtés de celle-ci sont en saillie des embases de crochets dont les faces inférieures s'écartent, au repos, vers le bas de la face inférieure de la plaque, la liaison de ces embases de crochets à ladite plaque de base étant déformable de façon que l'application de la face inférieure de la plaque de base contre le fond, amène la face inférieure desdites embases dans le même plan que cette face inférieure, et ainsi dispose les crochets en position active de fixation.

D'autres caractéristiques et avantages de l'invention apparaîtront avec la description de certains de ses modes de réalisation, celle-ci étant effectuée en se référant aux dessins ci-annexés sur lesquels :

- la figure 1 est une vue en perspective d'un dispositif selon l'invention en cours de montage et,

- la figure 2 est une vue partielle, également en perspective, du dispositif de la figure 1 après montage.

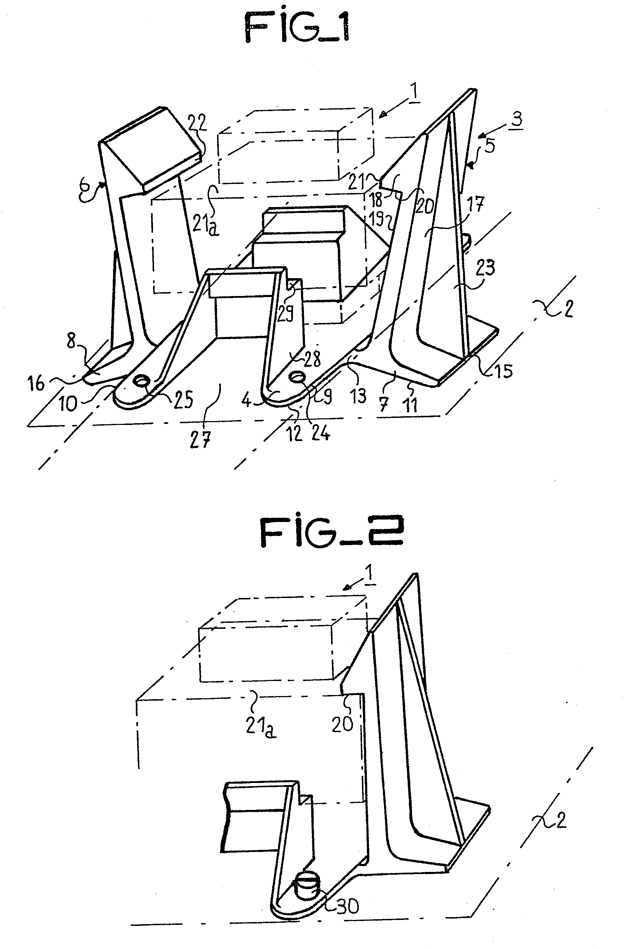

L'exemple de réalisation que l'on va décrire concerne la fixation d'un transformateur 1, représenté en traits mixtes sur les figures 1 et 2, à une plaque de fond 2 d'un appareil.

Pour cette fixation, on prévoit un dispositif 3 d'une seule pièce en matière plastique comportant, d'une part, une plaque de base 4, plate et de forme générale rectangulaire, et d'autre part, des crochets 5 et 6.

Chaque crochet 5 , 6 est solidaire d'une embase respectivement 7 , 8 rattachée à un grand côté correspondant 9 , 10 de la plaque de base 4.

Chaque embase, par exemple celle de référence 7, présente une face inférieure 11 qui forme un angle obtus avec le plan de la face inférieure 12 de la plaque 4 avant la fixation de cette dernière au fond 2 (figure 1). Cet angle est de sens tel que la face inférieure 11 s'éloigne vers le bas de la face 12 en partant de l'attache 13 de l'embase 7 à la plaque 4. Ainsi avant le montage, le dispositif de fixation 3 ne repose sur le fond 2 que par les arêtes d'extrémités 15 et 16, opposées aux attaches 13, des faces inférieures des embases 7 et 8, la plaque 4 étant à distance du fond 2.

Chaque crochet présente un corps 17 (pour celui de référence 5) ayant la forme générale d'une plaque rectangulaire, perpendiculaire à l'embase 7, et se termine par un redan 18 en saillie de la face 19 de ce corps qui est tournée vers l'autre crochet. Ce redan 18 présente une face inférieure 20 destinée à être appliquée, après le montage, contre la face supérieure $21_a$ du transformateur 1.

Le corps 17 étant perpendiculaire à l'embase 7, avant le montage ce corps forme un angle obtus avec la plaque de base 4 et l'extrémité 21 du redan 18, est en projection verticale, à l'extérieur de ladite plaque 4. De cette manière la distance entre les extrémités 21 et 22 des redans des deux crochets 5 et 6 est supérieure à la largeur du transformateur 1 et ces redans ne gênent donc pas l'introduction du transformateur 1 entre les crochets. En d'autres termes, il n'est pas nécessaire d'écarter les crochets 5 et 6 pour poser le transformateur sur la plaque de base 4 ou sur un autre support, comme on le verra plus loin.

Une nervure de raidissement 23 de forme générale rectangulaire est solidaire de la face supérieure de l'embase 7 et de la face externe du corps 17.

La plaque 4 présente au voisinage de chacun de ses coins un trou 24 , 25 pour permettre le passage d'une vis de fixation de cette plaque au fond 2.

Chaque petit côté de la plaque 4 comporte une échancrure 27 bordée par des parois 28 dont la partie supérieure présente un gradin 29 sur lequel vient reposer un épaulement du transformateur 1.

Pour effectuer le montage, le transformateur 1 est introduit entre les crochets 5 et 6, sa base reposant alors sur la plaque 4; en variante c'est l'épaulement susmentionné qui repose sur le gradin 29 (qui constitue un support solidaire de la plaque 4). Dans l'exemple, le poids du transformateur 1 est insuffisant pour appliquer la plaque 4 contre le fond 2 par déformation des attaches 13. Pour effectuer cette application, on fait appel à des vis 30 traversant les trous 24 , 25 aux quatre coins de la plaque 4 et vissées dans la plaque 2. Quand le vissage est terminé, la plaque 4 et les embases 7 et 8 sont appliquées contre le fond 2 et, ainsi, les crochets 5 et 6 sont mis en place, le redan 20 s'appliquant contre une face supérieure 21 $_a$ du transformateur.

Le corps de chaque crochet étant rattaché non élastiquement à l'embase correspondante qui est fermement appliquée contre le fond 2, ce corps reste bien en place et la fixation du transformateur est particulièrement sûre.

Le dispositif 3 étant en matière plastique, c'est à dire en un isolant électrique, isole le fond 2 du transformateur 1 qui est relié au secteur.

Il est bien entendu que dans ce qui précède et dans ce qui suit on a utilisé les expressions "supérieurs" et "inférieurs" pour la facilité de la description mais que l'invention n'est pas limitée à la disposition horizontale de la base 4 du dispositif de fixation.

## REVENDICATIONS

1. Dispositif de fixation d'un objet (1) à un fond (2) comprenant une plaque de base (4) fixable au fond et des crochets (5 , 6) solidaires de cette plaque, l'objet étant maintenu entre les redans (18) des crochets et ladite plaque ou un support (29) qui en est solidaire, caractérisé en ce que ce dispositif (3) est tel qu'avant le montage, les crochets sont éloignés l'un de l'autre afin que l'objet puisse être introduit sur la plaque (4) ou le support (29) sans avoir à écarter lesdits crochets, ces derniers étant installés en position active de fixation par l'application de la plaque de base (4) contre le fond (2).

2. Dispositif selon la revendication 1, caractérisé en ce que chaque crochet (5 , 6) présente un corps (17) solidaire d'une embase (7 , 8) qui est elle-même solidaire de la plaque de base (4) par une attache déformable (13) telle, qu'avant montage chaque embase forme un angle obtus avec la plaque de base, l'application de ladite plaque contre le fond (2) appliquant, par déformation de l'attache (13), l'embase (7 , 8) contre le fond (2) et assurant ainsi la mise en place des crochets.

3. Dispositif selon la revendication 2, caractérisé en ce que chaque crochet présente un corps (17) perpendiculaire à l'embase (7 , 8).

4. Dispositif selon la revendication 2 ou 3, caractérisé en ce que la liaison entre l'embase et le corps du crochet est rigide.

5. Dispositif selon la revendication 4, caractérisé en ce qu'il comporte une nervure de raidissement (23) solidaire du corps (17) du crochet et de l'embase (7).

6. Dispositif selon l'une quelconque des revendications précédentes, caractérisé en ce que l'application de la plaque de base (4) contre le fond (2) est assurée par des moyens de vissage (30).

7. Dispositif selon la revendication 6 caractérisé en ce que les moyens de vissage (30) sont aux quatre coins de la plaque de base (4) de forme générale rectangulaire.

8.Dispositif selon l'une quelconque des revendications précédentes caractérisé en ce qu'il est en matière plastique.

9. Application du dispositif selon l'une quelconque des revendications précédentes à la fixation d'un transformateur (1) au fond (2) d'un appareil.

# FIG_1

# FIG_2

Office européen
des brevets

**RAPPORT DE RECHERCHE EUROPEENNE**

**0122821**
Numéro de la demande

EP  84 40 0422

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. 3) |
|---|---|---|---|
| X | US-A-3 029 057  (NORTHROP CORP.) * Colonne 1, ligne 52 - colonne 2, ligne 35 * | 1,6 | H 05 K    7/12 F 16 B    9/02 |
| | --- | | |
| A | DE-A-2 236 724  (STANDARD ELEKTRIK LORENZ AG) | | |
| | --- | | |
| A | FR-A-1 426 331  (APPAREILLAGE THERMOFLEX ETABLISSEMENTS J.M. DARD) | | |
| | --- | | |
| A | EP-A-0 074 163  (THOMAS & BETTS CORP.) | | |
| | ----- | | |

**DOMAINES TECHNIQUES RECHERCHES (Int. Cl. 3)**

H 05 K
F 16 B
H 01 F

Le présent rapport de recherche a été établi pour toutes les revendications

| Lieu de la recherche LA HAYE | Date d'achèvement de la recherche 19-06-1984 | Examinateur SCHUERMANS N.F.G. |
|---|---|---|